# EUROPÄISCHE PATENTANMELDUNG

(11) **EP 1 113 336 A2**
(43) Veröffentlichungstag der Anmeldung: **04.07.2001**
(21) Anmeldenummer: 00124052.2
(22) Anmeldetag: 04.11.2000
(51) Int. Cl.: G03F 7/20

(54) **Optische Anordnung**

(30) Priorität: 29.12.1999 DE 19963588
(71) Anmelder: Carl Zeiss, 89518 Heidenheim (Brenz) (DE); Carl-Zeiss-Stiftung, trading as Carl Zeiss, 89518 Heidenheim (Brenz) (DE)
(72) Erfinder: Xalter, Stefan, 73447 Oberkochen (DE); Becker, Jochen, 73447 Oberkochen (DE); Bünau von, Rudolf, 73457 Essingen (DE); Wagner, Christian, 73430 Aalen (DE); Müller-Rissmann, Werner, 73447 Oberkochen (DE); Hümmel, Wolfgang, 73525 Schwäbisch Gmünd (DE); Holderer, Hubert, 89551 Königsbronn (DE)
(74) Vertreter: Ostertag, Ulrich, Dr.

(57) **Zusammenfassung**

Eine optische Anordnung, insbesondere eine Projektions-Belichtungsanlage der Mikrolithographie, weist insbesondere ein schlitzförmiges Bildfeld oder eine nicht rotationssymmetrische Beleuchtung auf. Dadurch wird ein optisches Element (101) von der Strahlung der Lichtquelle (110, 111, 112) nicht rotationssymmetrisch beaufschlagt. Das optische Element (101) weist eine absorbierende Beschichtung (104, 105) auf. Die Absorption der Beschichtung (104, 105) ist derart verteilt, daß sie in zur Intensitätsverteilung der Beaufschlagung durch die Strahlung (107, 108, 109) der Lichtquelle (110, 111, 112) zumindest annähernd komplementärer Weise nicht rotationssymmetrisch ist. Durch die in der Beschichtung (104, 105) absorbierte Energie erfolgt eine zusätzliche Beheizung des optischen Elements (101), die zu einer besser rotationssymmetrischen Temperaturverteilung führt, und dadurch ein Ausgleich lichtinduzierter Abbildungsfehler.

## Beschreibung

Die Erfindung betrifft eine optische Anordnung, insbesondere eine Projektions-Belichtungsanlage der Mikrolithographie, insbesondere mit schlitzförmiger Beleuchtung, mit mindestens einer Lichtquelle, die Strahlung emittiert, und einem optischen Element, das durch Beaufschlagung mit der Strahlung erwärmt wird, wobei die Beaufschlagung des optischen Elements durch die emittierte Strahlung der Lichtquelle mit nicht rotationssymmetrischer Intensitätsverteilung erfolgt.

Die Abbildungsqualität einer derartigen optischen Anordnung wird oftmals durch nicht rotationssymmetrische Abbildungsfehler gemindert. Derartige Abbildungsfehler entstehen z.B. außer durch nicht rotationssymmetrische lichtinduzierte Erwärmung des optischen Elements auch durch andere lichtinduzierte Effekte, wie z.B. "compaction", die eine entsprechende nicht rotationssymmetrische Ausdehnung bzw. Brechungsindexverteilung im optischen Element zur Folge haben.

Bei hohen Anforderungen an die Abbildungsqualität, wie sie insbesondere bei Projektions-Belichtungsverfahren in der Mikrolithographie gefordert sind, können die beschriebenen lichtinduzierten Abbildungsfehler nicht toleriert werden.

Aus der gattungsgemäßen EP 0 678 768 A2 ist es bekannt, über eine Symmetrisierung bzw. Homogenisierung der Temperaturverteilung durch eine zusätzliche Beheizung eine Verbesserung der Abbildungseigenschaften anzustreben. Die zusätzliche Beheizung erfolgt hier aktiv über mehrere Heizelemente, die an die Umfangsfläche einer Linse thermisch angekoppelt sind. Eine derartige Beheizung der Linse hat den Nachteil, daß die Umfangsfläche der Linse relativ stark beheizt werden muß, um trotz der in der Regel schlechten Wärmeleitungseigenschaften des Linsenmaterials im für die Abbildungseigenschaften meist relevanten Zentralbereich der Linse die gewünschte Symmetrisierung bzw. Homogenisierung der Temperaturverteilung zu erreichen. Eine starke Erwärmung im Umfangsbereich der Linse führt jedoch zur Gefahr einer Beschädigung der Linse und/oder der Linsenfassung durch thermische Spannungen.

Aufgrund des relativ großen Abstands zwischen dem Umfangsbereich und dem Zentralbereich, der durch die Strahlung einer der Projektion dienenden Lichtquelle beeinflußt wird, ist außerdem eine gezielte strukturierte Beeinflussung der Temperaturverteilung in der Umgebung des Zentralbereichs durch Heizen des Umfangsbereichs praktisch kaum möglich.

In der ebenfalls gattungsgemäßen EP 0 823 662 A2 erfolgt die zusätzlich Beheizung optischer Elemente zum Ausgleich der projektionslichtinduzierten Abbildungsfehler über die Einkopplung zusätzlicher Lichtquellen, die die optischen Elemente dort durch Absorption erwärmen, wo sie nicht vom Projektionslicht durchstrahlt werden. Da die Heizleistung durch die zusätzlichen Lichtquellen zur Symmetrisierung bzw. Homogenisierung der Temperaturverteilung derjenigen der Projektionslichtquelle vergleichbar sein muß, sind für die zusätzlichen Lichtquellen entweder Lichtleistungen in der Größenordnung derjenigen der Projektionslichtquelle erforderlich oder die zusätzlichen Lichtquellen müssen in Wellenlängenbereichen arbeiten, die stärker vom Material der optischen Elemente absorbiert werden. In beiden Fällen sind aufwendige zusätzliche Lichtquellen erforderlich. Im ersten Falle sind Lichtquellen mit hoher Leistung, im zweiten Falle Lichtquellen mit einer Wellenlänge erforderlich, die nicht kostengünstig verfügbar sind.

Es ist daher die Aufgabe der vorliegenden Erfindung, eine optische Anordnung der eingangs genannten Art derart weiterzubilden, daß mit einfachen Mitteln eine bessere Symmetrisierung bzw. Homogenisierung der Temperaturverteilung im optischen Element erreicht werden kann.

Diese Aufgabe wird erfindungsgemäß dadurch gelöst, daß
a) das optische Element eine absorbierende Beschichtung in einer derartigen räumlichen Verteilung aufweist, daß die Absorption der Beschichtung in zur Intensitätsverteilung der Beaufschlagung durch die Strahlung der Lichtquelle zumindest annähernd komplementärer Weise nicht rotationssymmetrisch ist.

Eine derartige absorbierende Beschichtung führt zu einer erhöhten Flexibilität, wenn eine vorgegebene zusätzliche Erwärmung der Linse über die Lichtabsorption eingestellt werden soll. Neue Freiheitsgrade, wie der Absorptionskoeffizient und die Form der absorbierenden Beschichtung stehen dann zur Beeinflussung der Verteilung der zusätzlichen Erwärmung zur Verfügung.

Bevorzugt umfaßt die absorbierende Beschichtung mindestens zwei Abschnitte, zwischen denen ein nicht absorbierend beschichteter Bereich verbleibt, dessen Ausdehnung quer zur Achse der Strahlung in mindestens einer Richtung kleiner ist als der in der gleichen Richtung gemessene Querschnitt der Strahlung. Dadurch kann die zusätzliche Beheizung über die Absorption vom Projektionslicht selbst bewerkstelligt werden. Dazu wird ein geringer Anteil des Pröjektionslichts in der Beschichtung absorbiert und führt über Wärmeleitung in der Beschichtung und thermische Ankopplung an das optische Element zur gewünschten Symmetrisierung bzw. Homogenisierung der Temperaturverteilung im optischen Element. Der in der Beschichtung absorbierte Anteil des Projektionslichts ist dabei so gering, daß die Projektionsqualität davon praktisch nicht beeinflußt wird.

Die absorbierende Beschichtung kann ein über ihre Fläche variierendes Absorptionsvermögen für Wellenlängen der Strahlung der Lichtquelle aufweisen. Dadurch ist eine weitergehende Anpassung der räumlichen Verteilung der zusätzlichen Heizung über die Lichtabsorption in der Beschichtung zur Symmetrisierung bzw. Homogenisierung der gesamten Temperaturverteilung des optischen Elements möglich.

Ein derartiges über die Fläche variierendes Absorptionsvermögen kann z.B. wie folgt realisiert werden:
Die absorbierende Beschichtung kann in ihrer Schichtdicke variieren. Auf diese Weise ist eine Beschichtung mit einheitlichem Material möglich, deren Absorptionsvermögen dennoch über die Fläche variiert.

Alternativ oder zusätzlich kann die absorbierende Beschichtung in ihrem Absorptionskoeffizienten räumlich variieren. Dadurch ist entweder eine Beschichtung mit über die Fläche variierendem Absorptionsvermögen bei konstanter Schichtdicke möglich, was für die Herstellung von Antireflex-Schichten von Vorteil ist, oder es ist ein zusätzlicher Freiheitsgrad für die Herstellung von über ihre Fläche variierend absorbierenden Beschichtungen gegeben. Im letzteren Falle lassen sich auch relativ komplexe Absorptionsstrukturen herstellen. Eine derartige Variation des Absorptionskoeffizienten kann z.B. durch gezieltes Dotieren der absorbierenden Beschichtung realisiert werden.

Bevorzugt weist die absorbierende Beschichtung in dem Bereich, der dem Zentrum der mit Strahlung beaufschlagten Oberfläche des optischen Elements am nächsten ist, das höchste Absorptionsvermögen auf. Die zur Symmetrisierung bzw. Homogenisierung erforderliche zusätzliche Heizung erfolgt dann in der Nachbarschaft des durch das Projektionslicht meist am stärksten beheizten Zentralbereichs des optischen Elements, so daß dort gezielt eine starke zusätzliche Heizung zur Symmetrisierung bzw. Homogenisierung erfolgen kann. Ein unnötiges Aufheizen weiter entfernter Bereiche, um über Wärmeleitung den Bereich in der Nachbarschaft des durch das Projektionslicht erwärmten Zentralbereichs zusätzlich zu beheizen, entfällt.

Bei einer Ausgestaltung der Erfindung weist die Lichtquelle eine Projektions-Lichtquelle und eine Ausgleichs-Lichtquelle auf, wobei die Strahlung der Ausgleichs-Lichtquelle auf die absorbierende Beschichtung gerichtet ist. Der Absorptionskoeffizient der Beschichtung und die Ausgleichs-Lichtquelle können derart aufeinander abgestimmt werden, daß Ausgleichs-Lichtquellen mit sehr geringer Lichtleistung und einer Standard-Emissionswellenlänge, die entsprechend kostengünstig und weniger aufwendig als beim Gegenstand der oben erwähnten EP 0 823 662 A2 sind, eingesetzt werden können. So kann der Absorptionskoeffizient der Beschichtung z.B. an die Emissionswellenlänge bekannter preiswerter Lichtquellen, wie Laserdioden, angepaßt werden. Über die Beaufschlagungsflächen des optischen Elements mit Ausgleichslicht und über die Verteilung der Lichtleistung über die beaufschlagten Flächen ist eine zusätzliche Steuerung der Temperaturverteilung möglich. Ggf. kann die Zusatzheizung außerdem dadurch an die Erfordernisse angepaßt werden, daß die Größe bzw. die Position der mit Ausgleichslicht beaufschlagten Fläche eingestellt werden. Dies geschieht durch entsprechende Justage der Ausgleichs-Lichtquellen.

Die räumliche Verteilung der absorbierenden Beschichtung kann derart sein, daß durch die nicht rotationssymmetrische Absorption der Strahlung der Lichtquelle in einem optischen Element eine Kompensation von optischen Bildfehlern mindestens eines anderen optischen Elements erfolgt. Mittels einer derartigen Überkompensation ist der Ausgleich von Abbildungsfehlern eines Systems optischer Elemente möglich. Nur eines dieser optischen Elemente muß dabei eine absorbierende Beschichtung aufweisen.

Ausführungsbeispiele der Erfindung werden nachfolgend anhand der Zeichnung näher erläutert; es zeigen:
- Figur 1:: eine Aufsicht auf eine erfindungsgemäß beschichtete Linse;
- Figur 2:: einen Schnitt gemäß Linie II-II von Figur 1, der zusätzlich die Randstrahlen eines die Linse beaufschlagenden Lichtbündels zeigt;
- Figur 3:: einen Schnitt gemäß Linie III-III von Figur 1;
- Figur 4:: die Linse der Figuren 1 bis 3 mit einer alternativen Lichtbeaufschlagung; und
- Figur 5:: einen Schnitt gemäß Linie V-V von Figur 4.

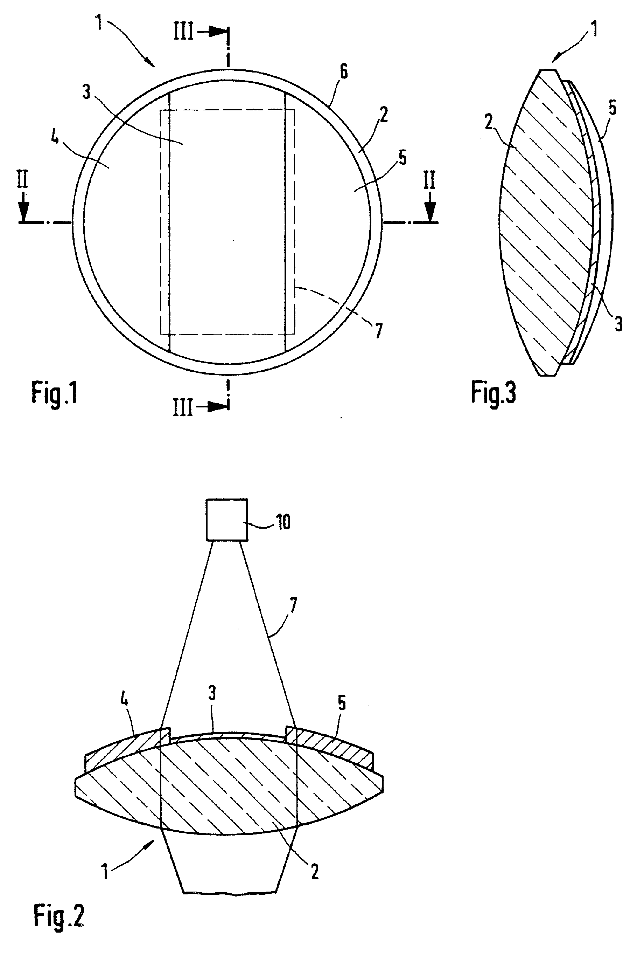

Die in den Figuren 1 bis 3 dargestellte Linse 1 ist Teil einer optischen Anordnung für eine Projektions-Belichtungsanlage für die Mikrolithographie.

Ein Grundkörper 2 der Linse 1 besteht aus einem gut für den Wellenlängenbereich der Strahlung einer Projektions-Lichtquelle 10, z.B. eines Argon-Fluorid-Excimerlasers, durchlässigen Material, z.B. Quarzglas oder CaF₂. Auf einer optischen Fläche ist der Grundkörper 2 dreiteilig beschichtet:

Einem zentralen Antireflex-Schichtstreifen 3 sind zwei Absorptions-Schichtsegemente 4, 5 derart benachbart, daß sie gemeinsam eine der optischen Flächen des Grundkörpers 2 bis auf einen freien Umfangsrandbereich 6, der im montierten Zustand der Linse 1 von einer Fassung (nicht dargestellt) aufgenommen wird, bedecken. Sowohl die Schichtdicken des Antireflex-Schichtstreifens 3 und der Absorptions-Schichtsegmente 4, 5 als auch das Verhältnis dieser Schichtdicken zueinander sind in der Zeichnung nicht maßstabsgetreu dargestellt.

Die Reflexion der Linse 1 wird durch den Antireflex-Schichtstreifen 3 im Bereich der Wellenlänge der Strahlung der Projektions-Lichtquelle 10 minimiert.

Die Schichtdicke des Antireflex-Schichtstreifens 3 ist über seine gesamte Fläche konstant. Die Absorptions-Schichtsegmente 4, 5 weisen hingegen eine kontinuierliche Variation ihrer Schichtdicke auf. Im Bereich der senkrecht zum Antireflex-Schichtstreifen 3 verlaufenden Meridionalebene der Linse 1 (Schnittebene der Figur 2) ist die Schichtdicke der Absorptions-Schichtsegemente 4, 5 am größten, während sie in der dazu senkrechten Richtung (parallel zur Schnittebene der Figur 3) zum Rand des Grundkörpers 2 hin kontinuierlich abnimmt.

Die Linse 1 wird im Rahmen des Mikrolithographie-Verfahrens mit einem rechteckigen Projektions-Lichtbündel 7, der Projektions-Lichtquelle 10 bestrahlt. Die Querschnittsfläche des Projektions-Lichtbündels 7 ist im Bereich des Durchtritts durch die Linse 1 in Figur 1 gestrichelt dargestellt und hat ein Seitenlängenverhältnis der Längszur Schmalseite von ungefähr 2:1.

Bei der in Figur 1 dargestellten Lichtbeaufschlagung ist die Schmalseite des Projektions-Lichtbündels 7 breiter als die Breite des Antireflex-Schichtstreifens 3, so daß Randbereiche des Projektionslichtbündels 7 die Absorptions-Schichtsegmente 4, 5 durchdringen.

Die beschichtete Linse 1 funktioniert folgendermaßen:
Durch das im Bereich der Linse 1 eine rechteckige Querschnittsfläche aufweisende Projektions-Lichtbündel 7 wird die Linse 1 aufgrund der Restabsorption des Materials des Grundkörpers 2 im Bereich der Wellenlänge des Projektions-Lichtbündels 7 erwärmt. Diese Erwärmung hat zunächst die Symmetrie des Lichtkanals des Projektions-Lichtbündels 7 im Grundkörper 2. Sie führt sowohl zu einer thermischen Ausdehnung des Materials als auch zu einer Brechungsindexänderung und daher, bedingt durch die geänderten Brechungseigenschaften, zu einer Änderung der Abbildungseigenschaften der Linse 1.

Ziel der Absorption der Strahlung des Projektions-Lichtbündels 7 in den Absorptions-Schichtsegmenten 4, 5 ist es, durch eine resultierende zusätzliche Erwärmung in zur Erwärmung durch das Projektions-Lichtbündel 7 komplementärer Weise eine Symmetrisierung bzw. eine vorgegebene Form der Temperaturverteilung in der Linse 1 zu erreichen, die zu gut kontrollierbaren Abbildungseigenschaften der Projektions-Belichtungsanlage führt.

Bei der in Figur 1 gezeigten Lichtbeaufschlagung der Linse 1 mit dem Projektions-Lichtbündel 7 erfolgt die zusätzliche Erwärmung in den Bereichen, in denen das Projektions-Lichtbündel 7 die Absorptions-Schichtsegmente 4, 5 durchdringt. Da das Material der Absorptions-Schichtsegmente 4, 5 einen räumlich konstanten Absorptionskoeffizienten aufweist, ist deren absolute Absorption im Bereich der Schnittebene der Figur 2, in der die Schichtdicke der Absorptions-Schichtsegmente 4, 5 am größten ist, am höchsten. Daher erfolgt dort die stärkste zusätzliche Erwärmung des Grundkörpers 2 über die absorbierte Energie in den Absorptions-Schichtsegmenten 4, 5.

Diese zusätzlich absorbierte Energie verteilt sich durch Wärmeleitung in den Absorptions-Schichtsegmenten 4, 5. Über die thermische Ankopplung der Absorptions-Schichtsegmente 4, 5 an den Grundkörper 2 resultiert eine Erwärmung von nicht vom Projektions-Lichtbündel 7 beaufschlagten Bereichen des Grundkörpers 2 in der Nachbarschaft der Längsseiten der Querschnittsfläche des Projektions-Lichtbündels 7.

Die Schichtdickenverteilung der Absorptions-Schichtsegmente 4, 5 ist dabei so gewählt, daß sich durch die beiden Beiträge der Erwärmung, also die Restabsorption im Grundkörper 2 einerseits und die Absorption in den Absorptions-Schichtsegmenten 4, 5 andererseits eine Temperaturverteilung im Grundkörper 2 ergibt, die der erwünschten Rotationssymmetrie näher kommt als die Temperaturverteilung, die sich ohne Aborptions-Schichtsegmente 4, 5 einstellen würde.

Eine Variation der Absorption in den Absorptions-Schichtsegmenten 4, 5 kann nicht nur durch eine Schichtdickenvariation, sondern auch durch eine räumliche Variation des Absorptionskoeffizienten des Materials der Absorptions-Schichtsegmente 4, 5 erreicht werden. Dazu werden beispielsweise die Absorptions-Schichtsegemente 4, 5 in den Bereichen, in denen eine höhere Absorption erwünscht ist, entsprechend dotiert. In diesem Falle können die Absorptions-Schichtsegmente 4, 5 über ihre Fläche eine konstante Schichtdicke aufweisen (nicht dargestellt).

Die der beschriebenenen dreiteiligen Beschichtung gegenüberliegende optische Fläche der Linse 1 trägt im Regelfall eine Antireflex-Beschichtung (nicht dargestellt). Natürlich können auch beide Durchtrittsflächen die dreiteilige Beschichtung aufweisen.

Auch durch eine alternative Formgebung der Flächen der Absorptions-Schichtsegmente kann ein Beitrag zur Symmetrisierung der Temperaturverteilung im Grundkörper 2 bei der Lichtbeaufschlagung mit einem Projektions-Lichtbündel erzielt werden.

Statt einer Symmetrisierung der Temperaturverteilung im Grundkörper 2 kann dort auch mit Hilfe der Absorptions-Schichtsegmente 4, 5 eine gezielte Überkompensation des Abbildungsverhaltens der Linse 1 erzielt werden. Ist die Linse 1 beispielsweise Teil einer mehrere benachbarte Linsen umfassenden optischen Anordnung, so kann mit einer gezielten Überkompensation der Abbildungseigenschaften der einen Linse 1 der durch die asymmetrische Erwärmung in den benachbarten Linsen erzeugte Abbildungsfehler kompensiert werden. Dazu wird beispielsweise durch die zusätzliche Erwärmung des Grundkörpers 2 der einen Linse 1 durch die Absorption in den Absorptions-Schichtsegmenten 4, 5 ein Astigmatismus im Grundkörper 2 erzeugt, der in etwa um 90° gedreht demjenigen Astigmatismus entspricht, der alleine durch die Erwärmung der anderen Linsen der optischen Anordnung über die Restabsorption in den Grundkörpern 2 entstehen würde.

Die Anwendung der beschriebenen Absorptions-Schichtsegmente ist nicht auf refraktive optische Elemente, wie z.B die Linse 1, beschränkt. Auch reflektive optische Komponenten, wie z.B. ein Spiegel oder ein Reflexionsgitter, können mit derartigen Absorptions-Schichtsegmenten versehen sein, um dort durch eine gezielte zusätzliche Erwärmung über die Absorption der Strahlung eines Projektions- und/oder eines Ausgleichs-Lichtbündels (vgl. unten) eine Kompensation von Bildfehlern zu erreichen.

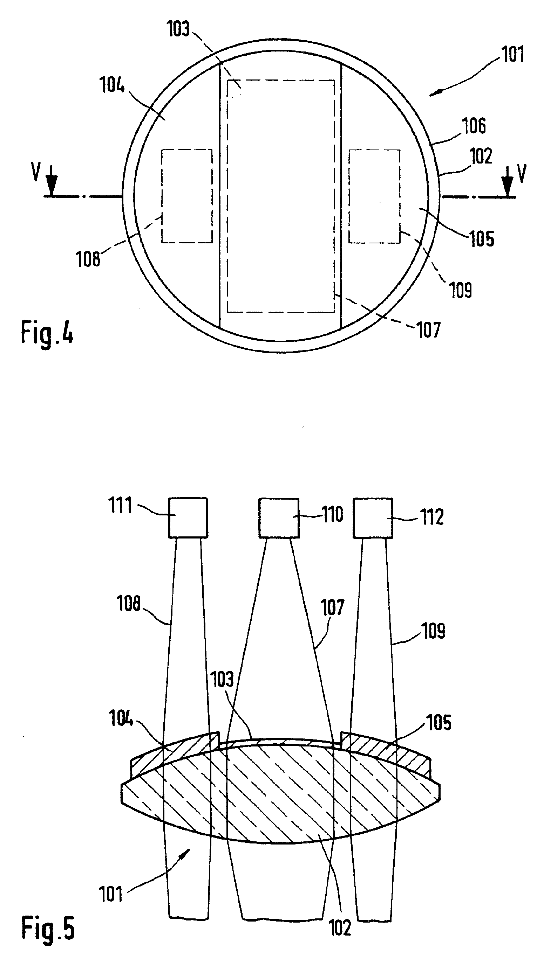

Eine alternative Lichtbeaufschlagung einer Absorptions-Schichtsegmente 104, 105 aufweisenden Linse 101 zeigen die Figuren 4 und 5. Komponenten, die denjenigen der Figuren 1 bis 3 entsprechen, tragen um 100 erhöhte Bezugszeichen und werden nicht nochmals im einzelnen erläutert.

In Figur 4 liegt die gesamte Querschnittsfläche des die Linse 101 durchdringenden Projektions-Lichtbündels 107 innerhalb der Fläche des Antireflex-Schichtstreifens 103. Die Absorptions-Schichtsegmente 104, 105 sind mit Ausgleichslichtbündeln 108, 109 von Ausgleichslichtquellen 111, 112, z.B. von Laserdioden, beaufschlagt.

Bei der in Figur 4 dargestellten Lichtbeaufschlagung erfolgt die zusätzliche Erwärmung zur Symmetrisierung der Temperaturverteilung im Grundkörper 102 durch die Absorption der Strahlung der beiden Ausgleichs-Lichtbündel 108, 109. Das Ausmaß der zusätzlichen Erwärmung kann hier einerseits über die Absorption der Absorptions-Schichtsegmente 104, 105 und andererseits über die Strahlungsleistung der Ausgleichs-Lichtbündel 108, 109 eingestellt werden. Diese Einstellung erfolgt gegebenenfalls gesteuert und abhängig von den Signalen eines die Abbildungsqualität der Linse 1 bzw. der optischen Anordnung der Projektions-Belichtungsanlage überwachenden Sensors (nicht dargestellt). Ein derartiger Sensor kann ein zweidimensionales CCD-Array sein, auf das eine Bildebene der optischen Anordnung abgebildet wird.

## Patentansprüche

1. Optische Anordnung, insbesondere Projektions-Belichtungsanlage der Mikrolithographie, insbesondere mit schlitzförmiger Beleuchtung, mit mindestens einer Lichtquelle, die Strahlung emittiert, und einem optischen Element, das durch Beaufschlagung mit der Strahlung erwärmt wird, wobei die Beaufschlagung des optischen Elements durch die emittierte Strahlung der Lichtquelle mit nicht rotationssymmetrischer Intensitätsverteilung erfolgt;
dadurch gekennzeichnet, daß
a) das optische Element (1; 101) eine absorbierende Beschichtung (4, 5; 104, 105) in einer derartigen räumlichen Verteilung aufweist, daß
b) die Absorption der Beschichtung (4, 5; 104, 105) in zur Intensitätsverteilung der Beaufschlagung durch die Strahlung (7; 107, 108, 109) der Lichtquelle (10; 110, 111, 112) zumindest annähernd komplementärer Weise nicht rotationssymmetrisch ist.

2. Optische Anordnung nach Anspruch 1, dadurch gekennzeichnet, daß die absorbierende Beschichtung mindestens zwei Abschnitte (4, 5) umfaßt, zwischen denen ein nicht absorbierend beschichteter Bereich (3) verbleibt, dessen Ausdehnung quer zur Achse der Strahlung (7) in mindestens einer Richtung kleiner ist als der in der gleichen Richtung gemessene Querschnitt der Strahlung (7).

3. Optische Anordnung nach Anspruch 1 oder 2, dadurch gekennzeichnet, daß die absorbierende Beschichtung (4, 5; 104, 105) ein über ihre Fläche variierendes Absorptionsvermögen für Wellenlängen der Strahlung (7; 107, 108, 109) der Lichtquelle (10; 111, 112) aufweist.

4. Optische Anordnung nach Anspruch 3, dadurch gekennzeichnet, daß die absorbierende Beschichtung (4, 5; 104, 105) in ihrer Schichtdicke variiert.

5. Optische Anordnung nach Anspruch 3 oder 4, dadurch gekennzeichnet, daß die absorbierende Beschichtung in ihrem Absorptionskoeffizienten räumlich variiert.

6. Optische Anordnung nach einem der Ansprüche 3 bis 5, dadurch gekennzeichnet, daß die absorbierende Beschichtung (4, 5; 104, 105) in dem Bereich, der dem Zentrum der mit Strahlung beaufschlagten Oberfläche des optischen Elements am nächsten ist, das höchste Absorptionsvermögen aufweist.

7. Optische Anordnung nach einem der vorhergehenden Ansprüche, dadurch gekennzeichnet, daß die Lichtquelle eine Projektions-Lichtquelle (110) und eine Ausgleichslichtquelle (111, 112) aufweist, wobei die Strahlung (108, 109) der Ausgleichs-Lichtquelle (111, 112) auf die absorbierende Beschichtung (104, 105) gerichtet ist.

8. Optische Anordnung nach einem der vorhergehenden Ansprüche, gekennzeichnet durch eine räumliche Verteilung der absorbierenden Beschichtung (104, 105) derart, daß durch die nicht rotationssymmetrische Absorption der Strahlung (7; 107, 108, 109) der Lichtquelle (10; 110, 111, 112) in einem optischen Element eine Kompensation von optischen Bildfehlern mindestens eines anderen optischen Elements erfolgt.
